# EUROPEAN PATENT SPECIFICATION

(11) **EP 1 681 722 B1**
(45) Date of publication and mention of the grant of the patent: **28.09.2011**
(21) Application number: 05257881.2
(22) Date of filing: 20.12.2005
(51) Int. Cl.: H01L 27/146

(54) **Multilayered semiconductor substrate and image sensor formed thereon for improved infrared response**
Mehrschichtiges Halbleitersubstrat und darauf gebildeter Bildsensor zur verbesserten Infrarotempfindlichkeit
Substrat semiconducteur multicouches et capteur d'images formé sur celui-ci pour améliorer la réponse infrarouge

(30) Priority: 18.01.2005 US 38594
(43) Date of publication of application: 19.07.2006
(73) Proprietor: OmniVision Technologies, Inc., Sunnyvale, California 94089 (US)
(72) Inventor: Rhodes, Howard E., Boise, ID 83706 (US)
(74) Representative: Hackney, Nigel John

(56) References cited:
- EP-A- 0 515 859
- WO-A-02/33755
- US-A1- 2003 025 131
- US-A1- 2004 266 145
- US-A1- 2005 006 565
- US-B1- 6 403 975

## Description

The present invention relates to a CMOS image sensor formed on a multilayered semiconductor substrate.

Image sensors have become ubiquitous. They are widely used in digital still cameras, cellular phones, security cameras, medical, automobile, and other applications. The technology used to manufacture image sensors, and in particular CMOS image sensors, has continued to advance at great pace.

However, current image sensors have very poor sensitivity in the wavelength range of 700 nm to 1000 nm. This wavelength range is loosely referred to as the infrared region of the electromagnetic spectrum. Both CCD and CMOS image sensors suffer from this poor sensitivity. This results from a particular characteristic of silicon semiconductor technology. Specifically, silicon has an energy band gap (EG) of 1.12 eV. Thus, for an electron to be created by the absorption of an incident photon, the photon must have a minimum energy of 1.12 eV to cause an electron in the silicon valence band to be excited to the silicon conduction band. This minimum photon energy is the silicon band gap energy of 1.12 eV. This amount of minimum energy corresponds to a photon wavelength of less than or equal to 1100 nm. Photons having a wavelength of 1100 nm or greater are not absorbed at all and pass through the silicon sensor without being detected.

Further, as the wavelength of light approaches 1100 nm, the absorption coefficient of the light dramatically decreases so that the sensitivity for detecting photons in the wavelength range of 700 nm to 1100 nm dramatically degrades. The photons are in fact absorbed too deep in the silicon to be detected by the photosensitive element which is typically located near the surface region of the semiconductor substrate. Even at 700 nm the average photon penetration depth is 5 µm below the surface. This is well below the depletion region of the photodiode. So even at 700 nm it is difficult for the photodiode to collect the electrons generated by photons with a wavelength of 700 nm. Longer wavelengths are even more difficult to collect.

EP 0515859 A1 discloses a multilayered silicon-germanium structure and associated process. The multilayered structure incorporates a single crystal silicon substrate and a plurality of silicon-germanium epitaxial layers having graded composition.

US2005/006565 A1 discloses an imager having a pixel cell having an associated strained silicon layer stocked on a silicon-germanium base layer and a silicone substrate. The strained silicon layer is used to increase charge transfer efficiency, to decrease image lag, and to improve blue response.

Automotive image sensors are one example of an application requiring improved performance in the infrared spectrum. For example, in one application, passengers are exposed to infrared radiation in the wavelength range of 850 nm to 950 nm. The image sensor is required to see the passengers under this illumination. This allows the location and size of the passengers to be determined even at night when there is no other illumination on the passengers. This information could then be used to determine the conditions for proper airbag deployment in the case of an accident.

Thus, it would be advantageous to have an image sensor with improved sensitivity in the near infrared wavelengths of 800 nm to 1100 nm.

In a first aspect, the present invention provides a CMOS image sensor according to Claim 1.

### BRIEF DESCRIPTION OF THE DRAWINGS

Figure 1 is a cross-sectional view of a prior art four transistor pixel.
Figure 2 shows a first embodiment of a multilayered semiconductor substrate formed in accordance with the present invention with a four transistor pixel formed therein.
Figure 3 is an example of a multilayered semiconductor substrate with a four transistor pixel formed therein, which does not form part of the claimed invention.
Figure 4 is another example of a multilayered semiconductor substrate with a four transistor pixel formed therein, which does not form part of the claimed invention.
Figure 5 is yet another example of a multilayered semiconductor substrate with a four transistor pixel formed therein, which does not form part of the claimed invention.

### DETAILED DESCRIPTION

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

Reference throughout the specification to "one embodiment" or "an embodiment" means that a particular feature, structure, or characteristic described in connection with the embodiment and included in at least one embodiment of the present invention. Thus, the appearances of the phrase "in one embodiment" or "in an embodiment" in various places throughout the specification are not necessarily all referring to the same embodiment.

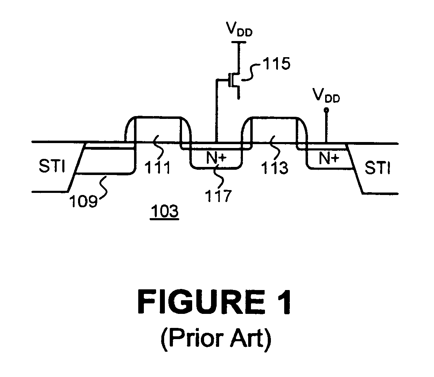

Figure 1 shows a combination cross-sectional view of a prior art image sensor and active pixel that uses four transistors. This is known in the art as a 4T active pixel. However, it can be appreciated that the multilayered semiconductor substrate of the present invention can be used with any type of pixel design, including but not limited to 3T, 5T, 6T, and other designs, as well as with CCD or CMOS image sensors..

Figure 1 shows a cross-section of a four-transistor a pixel 103, which is only one exemplar pixel in the pixel array. The pixel includes a photosensitive element 109, which in this embodiment is a pinned photodiode. However, the photosensitive element may be a photogate, photocapacitor, partially pinned photodiode, or unpinned photodiode. Further, the term pixel as used herein is meant to encompass all pixel designs, including CCD pixels.

The photodiode 109, outputs a signal that is used to modulate an amplification transistor 115. The amplification transistor 115 is also referred to as a source follower transistor. A transfer transistor having a transfer gate 111 is used to transfer the signal output by the photodiode 109 to a floating node 117 (N+ doped) and the gate of the amplification transistor 115.

In operation, during an integration period (also referred to as an exposure or accumulation period), the photodiode 109 stores charge (in response to incident light) that is held in the N layer of the photodiode 109. After the integration period, the transfer gate 111 is turned on to transfer the charge held in the N- layer to the floating node 117. After the signal has been transferred to the floating node 117, the transfer gate 117 is turned off again for the start of a subsequent integration period. The signal on the floating node 117 is then used to modulate the amplification transistor 115. After readout, a reset transistor having a reset gate 113 resets the floating node 117 to a reference voltage. In one embodiment, the reference voltage is V_{dd}.

The present invention uses a multilayered semiconductor substrate in order to increase sensitivity in the infrared spectrum. In the drawings and description detailed below, particular emphasis is placed upon the particular layers and composition of the semiconductor substrate. The steps in the formation of the pixels of the image sensor are not described in detail to avoid obscuring the present invention. There are a multitude of various structures and methods used to form CMOS and CCD image sensors and the present invention can be used with each of them.

For a more complete description of image sensor technology, please refer to my copending U.S. Patent Application Serial No. 10/966,137 filed October 15, 2004 entitled "Image Sensor and Pixel that has Positive Transfer Gate Voltage During Integration" and/or U.S. Patent Application Serial No. 11/007,859 filed December 9, 2004 entitled "Local Interconnect Structure and Method for a CMOS Image Sensor".

In current CCD and CMOS image sensors, the semiconductor substrate is typically either n-type silicon, p-type silicon, or p+ silicon with a surface p-type epitaxial layer. In each of these cases, the substrate is based on silicon, with dopants that modify the conductivity of the substrate, but do not change its fundamental absorption characteristics.

While it is true that a heavily doped p+ silicon substrate will have an increased absorption coefficient due to "free carrier" absorption, this phenomena is not useful in the imaging context because electron-hole pairs are not created. Further, the use of a p+ silicon substrate having an abundance of holes provides very fast recombination that eliminates any generated electrons.

In accordance with the present invention, a silicon-germanium (SiGe) alloy is used to aid in absorbing near infrared incident photons using the photoelectric effect. The energy band gap of silicon is reduced as it is alloyed with germanium, substantially increasing the absorption coefficients, especially at longer wavelengths. However, it has been recognized that such a SiGe alloy would make it difficult to form an oxide of germanium that is stable. Without stable oxide formation, it is difficult to make gate dielectrics so commonly used in CMOS processes.

Because the absorption coefficient at shorter wavelengths (i.e., the visible spectrum) is not an issue for an infrared sensor, the present invention, in one embodiment, proposes a multilayered structure to take advantage of the properties of silicon and silicon-germanium alloys. In particular, as detailed below, there is a surface layer of silicon that can be doped for forming transistors, photodiodes, oxides, and diffusions. The surface silicon layer is in the range of thickness from 10 nm to 3 µm, and preferably between 50 nm and 1 µm. By using a SiGe alloy, the absorption at all wavelengths is increased and the absorption coefficients in the visible spectrum are also increased. Since the electrons are generated closer to the surface and closer to the photodiode, there is less chance for the generated electron to diffuse to the adjacent pixel's photodiode. This improves crosstalk at all wavelengths, which is a benefit for both visible and IR sensors. Thus, while this invention is of particular benefit to IR sensors, the teachings of the present invention may also be used advantageously for sensors designed to operate in the visible spectrum.

Underneath the silicon layer is a silicon-germanium layer. In the light sensitive area, e.g. the photodiode region, the buried silicon-germanium layer is very effective in absorbing photons via the photoelectric effect which create electron-hole pairs. These charged particles can be separated through the combination of well known doping profiles and the application of voltage driving forces.

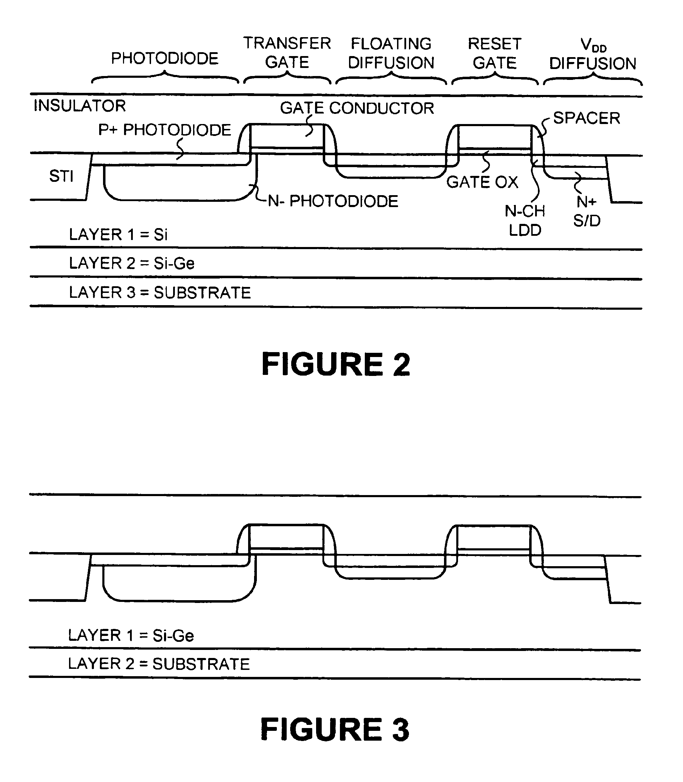

For example, turning to Figure 2, there is shown a multilayered semiconductor substrate. Figure 2 shows three layers denoted as Layer 1, Layer 2, and Layer 3. The bottom most layer, Layer 3, is the base substrate. This base substrate may be, as some examples, a p-type substrate, an n-type substrate, or any conventional silicon based substrate.

As further examples, for pixel arrays that use n-channel transistors, Layer 3 may either be a p-type silicon, a p+ silicon substrate, or a p-type epitaxial silicon layer over a p+ silicon substrate. For pixel arrays that use p-channel transistors, Layer 3 may be an n-type silicon, an n+ silicon substrate, or a n-type epitaxial silicon layer over a n+ silicon substrate.

Layer 2 is a silicon-germanium alloy layer. For pixel arrays that use n-channel transistors, the silicon-germanium alloy layer may be p-type doped. For pixel arrays that use p-channel transistors, the silicon-germanium alloy layer may be n-type doped. The silicon-germanium allow may be formed using an epitaxial growth process. In one embodiment, the SiGe alloy layer (Layer 2) is approximately 1 µm to 20 µm thick. For the aforementioned case of pixel arrays that use n-channel transistors, the SiGe alloy is doped p-type. This doping can be done insitu during the epitaxial growth or with a subsequent p-type implant. The p-type doping concentration in the SiGe alloy may be in the range of 1E14/cm³ to 1E16/cm³, and preferably 3E14/cm³ to 4E15/cm³.

Finally, formed atop of the silicon-germanium layer is a silicon layer (Layer 1), which may be p-type for pixel arrays using n-channel transistors. For pixel arrays using p-channel transistors, the silicon layer (Layer 1) may be n-type. Note that the thickness of the silicon layer (Layer 1) is adequate to contain the pixel structures formed on the substrate, including the photodiode, the various N+ and n- doped regions, and the shallow trench isolations (STI) regions. The surface silicon layer (Layer 1) is in the range of 10 nm to 3 µm, and preferably 50 nm to 1 µm. The depletion region of the voltage biased photodiode extends into the SiGe layer and is effective in collecting electrons generated in the SiGe layer.

Turning to Figure 3, in an example not forming part of the claimed invention, the silicon-germanium alloy layer (Layer 1) is formed directly atop of the underlying substrate (Layer 2). The top surface is silicon-germanium and not silicon, in contrast to the embodiment shown in Figure 2. Thus, the structures and doped regions forming the pixel are formed directly in the silicon-germanium layer (Layer 1). For pixel arrays that use n-channel transistors, the silicon-germanium layer (Layer 1) is p-type and the substrate (Layer 2) is also p-type. For pixel arrays using p-channel transistors, both the silicon-germanium layer (Layer 1) and the substrate (Layer 2) are n-type. In this example not forming part of the claimed invention, where the surface layer is silicon-germanium, the concentration of germanium relative to silicon increases with depth, such that there is a relatively low germanium concentration at the surface and a relatively high doping concentration at the bottom of the silicon-germanium layer (Layer 1).

While it can be advantageous for the SiGe layer to have a Ge doping gradient, it is also contemplated that a SiGe alloy of a single uniform alloy composition may be used. Still, the doping gradient of germanium may be advantageous in forming an oxide on the surface. By reducing the germanium concentration near the surface, this will enhance oxide formation. However, by using a SiGe alloy with sufficient Ge concentration to provide a useful increase in light absorption and still be able to grow a stable oxide, then a single, uniform SiGe alloy could be realized.

The SiGe alloy layer (Layer 1 in Fig 3) is approximately 1 µm to 20 µm thick. For the aforementioned case of pixel arrays that use n-channel transistors the SiGe alloy is doped p-type. This doping can be done insitu during the epitaxial growth or with a subsequent p-type implant. The p-type doping concentration in the SiGe alloy is approximately 1E14/cm³ to 1E16/cm³, and preferably 3E14/cm³ to 4E15/cm³.

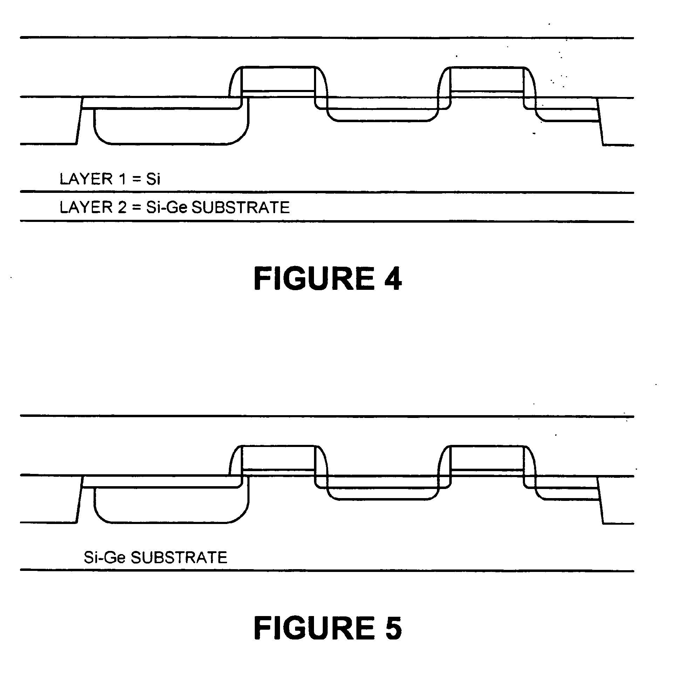

Turning to Figure 4, in another example not forming part of the claimed invention, the substrate layer (Layer 2) is formed from silicon-germanium and an epitaxial silicon layer (Layer 1) is grown atop the silicon-germanium substrate. This example not forming part of the claimed invention is similar to the embodiment of Figure 2 except that the silicon-germanium layer is also used as the substrate. The surface silicon layer (Layer 1) may have a thickness in the range of 10 nm to 3 µm thick, and preferably between 50 and 1 µm thick. Both the surface silicon layer and the SiGe substrate should be doped p-type for the case of a pixel array formed using n-channel transistors. The p-type doping concentration in both the surface silicon layer and the SiGe alloy is approximately 1e14/cm³ to 1e16/cm³, and preferably between 3e14/cm³ to 4e15/cm³.

Further, in yet another example not forming part of the claimed invention as seen in Figure 5, the pixel is formed directly onto a silicon-germanium substrate. While in one such example, the germanium has a uniform concentration gradient, in alternative examples not forming part of the claimed invention, the germanium has a concentration gradient where the concentration of germanium at the surface of the silicon-germanium substrate is relatively low compared to that deeper into the substrate. In this example not forming part of the claimed invention, it is advantageous to have a low germanium doping concentration at the surface. The SiGe substrate should be doped p-type for the case of a pixel array formed using n-channel transistors. The p-type doping concentration in the SiGe alloy is approximately 1e14/cm³ to 1e16/cm³, and preferably between 3e14/cm³ to 4e15/cm³_{.}

Thus, from the foregoing, it will be appreciated that specific embodiments of the invention have been described herein for purposes of illustration, but that various modifications may be made. Accordingly, the invention is not limited except as by the appended claims.

## Claims

1. A CMOS image sensor including:
a multilayered semiconductor structure, said multilayered semiconductor structure including a silicon-germanium alloy layer formed over a silicon substrate;
wherein the multilayered semiconductor substrate further includes a silicon top layer formed over said silicon-germanium alloy layer; and
said silicon top layer has a thickness of between 10 nm to 3 µm,
**characterised in that**:
the CMOS image sensor includes an array of pixels (103), each pixel including a pinned photodiode (109), the doped regions of the pinned photodiode being contained in said silicon top layer.

2. The CMOS image sensor of Claim 1 wherein said silicon-germanium alloy layer has a thickness of between 1 µm to 20 µm.

3. The CMOS image sensor of Claim 1 wherein the pixel array uses n-channel transistors and the silicon top layer, the silicon-germanium alloy layer and the silicon substrate are p-type doped.

4. The CMOS image sensor of Claim 1 wherein the pixel array uses p-channel transistors and the silicon top layer, the silicon-germanium alloy layer and the silicon substrate are n-type doped.

5. The CMOS image sensor of Claim 1 wherein each pixel includes an amplification transistor (115).

## Patentansprüche

1. CMOS-Bildsensor, der Folgendes umfasst:
eine mehrschichtige Halbleiterstruktur, wobei die mehrschichtige Halbleiterstruktur eine Schicht aus einer Silicium-Germanium-Legierung umfasst, die über einem Siliciumsubstrat ausgebildet ist;
worin das mehrschichtige Halbleitersubstrat ferner eine Siliciumdeckschicht umfasst, die über der Schicht aus der Silicium-Germanium-Legierung ausgebildet ist, und worin die Siliciumdeckschicht eine Dicke zwischen 10 nm und 3 µm aufweist,
**dadurch gekennzeichnet, dass**:
der CMOS-Bildsensor eine Anordnung von Bildpunkten (103) umfasst, wobei jeder Bildpunkt eine gepinnte Photodiode (109) umfasst, wobei die dotierten Bereiche der gepinnten Photodiode in der Siliciumdeckschicht enthalten sind.

2. CMOS-Bildsensor nach Anspruch 1, worin die Schicht aus der Silicium-Germanium-Legierung eine Dicke zwischen 1 µm und 20 µm aufweist.

3. CMOS-Bildsensor nach Anspruch 1, worin die Bildpunktanordnung n-Kanal-Transistoren verwendet und die Siliciumdeckschicht, die Schicht aus der Silicium-Germanium-Legierung und das Siliciumsubstrat p-dotiert sind.

4. CMOS-Bildsensor nach Anspruch 1, worin die Bildpunktanordnung p-Kanal-Transistoren verwendet und die Siliciumdeckschicht, die Schicht aus der Silicium-Germanium-Legierung und das Siliciumsubstrat n-dotiert sind.

5. CMOS-Bildsensor nach Anspruch 1, worin jeder Bildpunkt einen Verstärkungstransistor (115) umfasst.

## Revendications

1. Capteur d'image CMOS comprenant :
une structure à semi-conducteur multicouche, ladite structure à semi-conducteur multicouche contenant une couche en alliage de silicium-germanium formée sur un substrat en silicium ;
dans lequel le substrat à semi-conducteur multicouche comprend en outre une couche supérieure en silicium formée au-dessus de ladite couche en alliage de silicium-germanium ; et
ladite couche supérieure en silicium a une épaisseur comprise entre 10 nm et 3 µm,
**caractérisé en ce que** :
le capteur d'image CMOS comprend un réseau de pixels (103), chaque pixel comprenant une photodiode clampée (109), les régions dopées de la photodiode clampée étant contenues dans ladite couche supérieure en silicium.

2. Capteur d'image CMOS selon la revendication 1, dans lequel ladite couche en alliage de silicium-germanium a une épaisseur comprise entre 1 µm et 20 µm.

3. Capteur d'image CMOS selon la revendication 1, dans lequel le réseau de pixels utilise des transistors à canal n, et la couche supérieure en silicium, la couche en alliage de silicium-germanium et le substrat en silicium sont dopés de type p.

4. Capteur d'image CMOS selon la revendication 1, dans lequel le réseau de pixels utilise des transistors à canal p, et la couche supérieure en silicium, la couche en alliage de silicium-germanium et le substrat en silicium sont dopés de type n.

5. Capteur d'image CMOS selon la revendication 1, dans lequel chaque pixel comprend un transistor d'amplification (115).
